# EUROPEAN PATENT APPLICATION

(11) **EP 4 481 773 A1**
(43) Date of publication of application: **25.12.2024**
(21) Application number: 23796604.9
(22) Date of filing: 08.03.2023
(51) Int. Cl.: H01F 27/36, H01F 17/06, H02M 1/44, G02F 1/1333, H01F 27/33, H01F 27/34, H01F 27/32, H02M 1/00

(54) **DISPLAY DEVICE AND ELECTRONIC DEVICE**

(30) Priority: 28.04.2022 KR 20220053113; 28.06.2022 KR 20220079298
(71) Applicant: Samsung Electronics Co., Ltd, Suwon-si, Gyeonggi-do 16677 (KR)
(72) Inventor: LEE, Jiwon, Suwon-si Gyeonggi-do 16677 (KR); JOO, Sungyong, Suwon-si Gyeonggi-do 16677 (KR)
(74) Representative: Appleyard Lees IP LLP
(86) International application number: PCT/KR2023/003137
(87) International publication number: WO 2023/210954

(57) **Abstract**

A display device and an electronic device are provided. The display device comprises: a display panel; a display case which supports the display panel and which includes a board mounting portion; a printed circuit board mounted on the board mounting portion; and a line filter mounted on the printed circuit board so as to reduce current noise, wherein the line filter includes: a core; a shielding member which is arranged between the core and the board mounting portion and which blocks electric fields or magnetic fields; a core case, which accommodates the core, has a coil wound around at least a portion of the outer side thereof, and includes a shielding support portion to support one surface of the board mounting portion of the shielding member.

## Description

### [Technical Field]

The present disclosure relates to a display device, and more particularly, to a display device including a line filter for reducing current noise.

### [Background Art]

Electronic devices such as display devices include a Power Supply Board that supplies power to drive the electronic devices, wherein the power supply board may be a Switched Mode Power Supply (SMPS) board.

The electronic devices generate electromagnetic waves for various reasons, and the electromagnetic waves affect the surrounding devices to act as noise interfering with the functions of the surrounding devices, or affect the human body. Therefore, international regulations to prevent electromagnetic waves are continuously made.

For example, the SMPS boards of electronic devices generates various noise due to the Electro Magnetic Interference (EMI) phenomenon that occurs during switching operations.

Accordingly, electronic devices are provided with various noise filters such as a line filter for passing current required for operations while removing noise.

### [Disclosure]

### [Technical Problem]

An aspect of the disclosure provides a display device and an electronic device with an improved structure for reducing current noise by including a line filter.

An aspect of the disclosure provides a display device and am electronic device with an improved structure for reducing vibration of a product by shielding an electric field or a magnetic field generated from a line filter.

An aspect of the disclosure provides a display device and an electronic device with an improved structure for miniaturizing a size of a product by reducing a distance between components.

An aspect of the disclosure provides a display device and an electronic device with an improved structure for simplifying a structure of a line filter and reducing manufacturing cost.

### [Technical Solution]

A display device according to an example of the disclosure may include a display panel, a display case supporting the display panel and including a board mounting portion, a printed circuit board mounted on the board mounting portion, and a line filter mounted on the printed circuit board and configured to reduce current noise, wherein the line filter includes a core, a shielding member positioned between the core and the board mounting portion and configured to shield an electric field or a magnetic field, and a core case in which the core is accommodated, wherein a coil is wound around at least a portion of an outer side of the core case, the core case including a shield support portion supporting one surface of the shielding member facing the board mounting portion.

The shielding member may extend in parallel to the board mounting portion, and the shield support portion may extend in parallel to the shielding member and the board mounting portion.

The shield support portion may include a first support portion facing the one surface of the shielding member facing the board mounting portion, and a second support portion supporting an outer edge of the shielding member, and the second support portion may be bent at and extend from one end of the first support portion.

The shield support portion may further include a third support portion facing the first support portion and supporting another surface of the shielding member which is opposite to the one surface of the shielding member facing the board mounting portion, and a groove formed between the first support portion, the second support portion, and the third support portion such that the shielding member is inserted in the groove.

The shielding member may be insertable into the groove in parallel to the board mounting portion.

The second support portion may connect the first support portion and the third support portion.

The first support portion and the second support portion may extend in directions that are orthogonal to each other.

The coil may be wound around the core case in such a way as to extend in parallel to the board mounting portion, and the shielding member may cover one side of the coil facing the board mounting portion.

The shield support portion may include a plurality of shield support portions arranged to be spaced from each other, and the plurality of shield support portions may be arranged in parallel to a direction in which the coil extends.

A portion of the one surface of the shielding member facing the board mounting portion may be covered by the shield support portion, and another portion of the one surface of the shielding member facing the board mounting portion may open.

The core may be formed in an annular shape, the core case may be formed in an annular shape in correspondence with the core, the coil may include a first coil wound around a first area of an outer side of the core and the core case and a second coil wound around a second area of the outer side of the core and the core case, the second area being opposite to the first area, the line filter may further include a separator configured to insulate the first coil and the second coil from each other, and the shielding member may be positioned between the separator and the board mounting portion.

The separator may be formed integrally with at least a portion of the core case adjacent to the board mounting portion.

The line filter may further include a connection pin fixed to the printed circuit board and including a conductive material, the coil may include a winding portion wound around the outer side of the core case and a connection end extending from the winding portion and connected to the connection pin, the shield support portion may include a coil through hole formed between the shielding member and the board mounting portion, and at least a part of the coil between the winding portion and the connection end may penetrate the coil through hole to prevent the shielding member from being separated from the shield support portion.

The printed circuit board may include a board hole in a location in which the line filter is mounted and formed to correspond to the core case, and at least a part of the shield support portion may be inserted in the board hole.

The display case may include a bottom chassis supporting a rear side of the display panel, and the board mounting portion may be on a rear side of the bottom chassis.

A display device according to another example of the disclosure may include a display panel displaying a screen, a bottom chassis supporting a rear side of the display panel, and a power supply board mounted on the bottom chassis and including a printed circuit board and a line filter mounted on the printed circuit board and configured to reduce current noise, wherein the line filter includes a core positioned in parallel to the bottom chassis, a coil positioned in parallel to at least a portion of the core, a shielding member positioned between the core and the bottom chassis and configured to shield an electric field or a magnetic field, and a core case in which the core is accommodated and around which the coil is wound, the core case including a shield support portion supporting one surface of the shielding member facing the bottom chassis.

The shielding member may extend in parallel to the bottom chassis, the shield support portion may include a groove extending in parallel to the bottom chassis, and the shielding member may be inserted in the groove in parallel to the bottom chassis.

The shielding member may cover one surface of the coil facing the bottom chassis.

The shielding member may include a magnetic material.

An electronic device according to an example of the disclosure may include a main body including a board mounting portion, a printed circuit board mounted on the board mounting portion, and a line filter electrically connected to the printed circuit board and configured to reduce current noise, wherein the line filter includes a core assembly including a core, a core base covering one side of the core and coupled with the printed circuit board, and a core cover covering another side of the core and coupled with the core base, a coil wound around an outer side of the core assembly, and a shielding member configured to shield an electric field and a magnetic field, positioned between the core and the board mounting portion to be parallel to the board mounting portion, and inserted in the core base such that one surface of the shielding member facing the board mounting portion is supported by the core base.

### [Advantageous Effects]

According to a concept of the disclosure, a display device and an electronic device may shield an electric field or a magnetic field generated from a line filter and reduce vibration of a product by including a core case for supporting a shielding member in the line filter.

According to a concept of the disclosure, a display device and an electronic device may reduce a distance between a line filter and another component and miniaturize a size of a product by including a shielding member.

According to a concept of the disclosure, a display device and an electronic device may simplify a structure of a line filter and reduce manufacturing cost by including a core case into which some components are integrated.

### [Description of Drawings]

FIG. 1 is a perspective view showing a display device according to an embodiment of the disclosure.
FIG. 2 shows the display device of FIG. 1 when a rear cover is separated from the display device.
FIG. 3 is a block diagram for schematically describing an operation of a power supply board in a display device according to an embodiment of the disclosure.
FIG. 4 is a circuit diagram schematically showing a noise filter for reducing current noise in a display device according to an embodiment of the disclosure.
FIG. 5 shows a line filter of a display device according to an embodiment of the disclosure.
FIG. 6 is an exploded perspective view of the line filter of FIG. 5.
FIG. 7 is a view of the line filter of FIG. 5, shown from below.
FIG. 8 is an exploded perspective view of the line filter of FIG. 5, shown from below.
FIG. 9 is a cross-sectional view taken along line X-X' of FIG. 5.
FIG. 10 shows a line filter of a display device according to another embodiment of the disclosure, wherein the line filter has a modified shape of a shield support portion.
FIG. 11 shows a line filter of a display device according to still another embodiment of the disclosure, wherein the line filter has a modified shape of a shield support portion.
FIG. 12 shows a line filter of a display device according to another embodiment of the disclosure, wherein the line filter does not include a separator.
FIG. 13 is an exploded perspective view of the line filter of FIG. 12.
FIG. 14 shows a line filter of a display device according to another embodiment of the disclosure, wherein the line filter is mounted in a modified shape on a printed circuit board.
FIG. 15 shows the line filter of FIG. 14 separated from the printed circuit board.
FIG. 16 is a cross-sectional view taken along line Y-Y' of FIG. 14.
FIG. 17 shows a line filter of a display device according to another embodiment of the disclosure, wherein the line filter is configured to prevent separation of a shielding member by a coil.
FIG. 18 is an enlarged view of A of FIG. 17.

### [Modes of the Invention]

Configurations illustrated in the embodiments and the drawings described in the present specification are only the preferred embodiments of the disclosure, and thus it is to be understood that various modified examples, which may replace the embodiments and the drawings described in the present specification, are possible when filing the present application.

Also, like reference numerals or symbols denoted in the drawings of the present specification represent members or components that perform the substantially same functions.

Also, the terms used in the present specification are merely used to describe embodiments, and are not intended to limit and/or restrict the disclosure. An expression used in the singular encompasses the expression of the plural, unless it has a clearly different meaning in the context. In the present specification, it is to be understood that the terms such as "including" or "having," etc., are intended to indicate the existence of the features, numbers, steps, operations, components, parts, or combinations thereof disclosed in the specification, and are not intended to preclude the possibility that one or more other features, numbers, steps, operations, components, parts, or combinations thereof may exist or may be added.

Also, it will be understood that, although the terms including ordinal numbers, such as "first", "second", etc., may be used herein to describe various components, these components should not be limited by these terms. These terms are only used to distinguish one component from another. For example, a first component could be termed a second component, and, similarly, a second component could be termed a first component, without departing from the scope of rights of the disclosure. As used herein, the term "and/or" includes any and all combinations of one or more of associated listed items.

Meanwhile, in the following description, the terms "front", "rear", "left", and "right" are defined based on the drawings, and the shapes and positions of the components are not limited by the terms.

Hereinafter, in the following description of an embodiment of the disclosure, for convenience of description, a display device as a kind of an electronic device will be described as an example. However, a concept of the disclosure is not limited thereto. The concept of the disclosure may be applied to various electronic devices to which a line filter for reducing current noise is applicable.

For example, an electronic device according to a concept of the disclosure may include a computer main body (not shown), etc. including a Central Processing Unit (CPU), etc. of a Personal Computer (PC) (not shown).

Also, in the disclosure, a flat panel display device will be described as an example. However, a configuration of the disclosure may be applied to a curved display device, or a Bendable or Flexible display device that may change between a flat state and a curved state. Also, the configuration of the disclosure may be applied to all display devices regardless of screen sizes of the display devices.

Hereinafter, an embodiment of the disclosure will be described in detail with reference to the accompanying drawings.

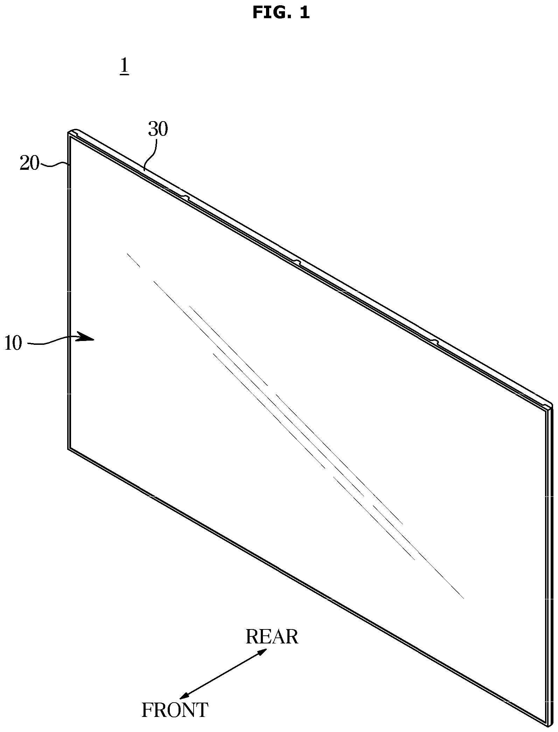

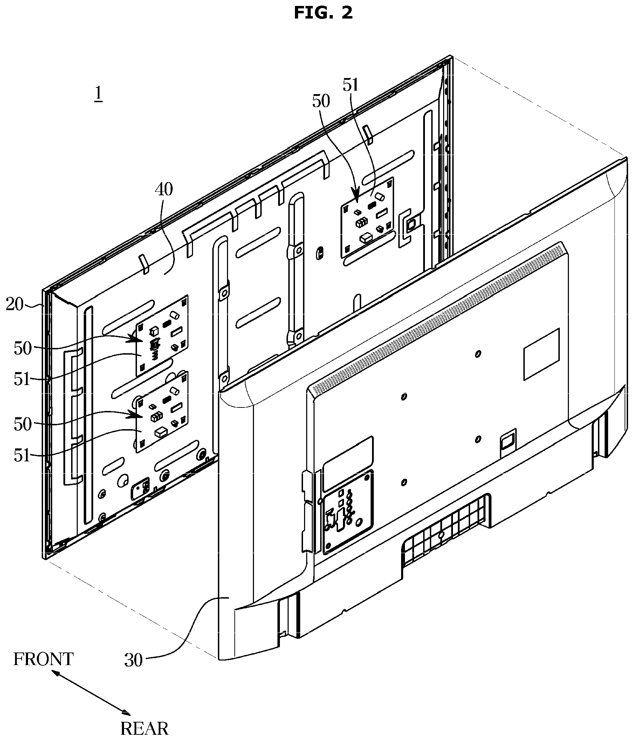

FIG. 1 is a perspective view showing a display device according to an embodiment of the disclosure. FIG. 2 shows the display device of FIG. 1 when a rear cover is separated from the display device.

Referring to FIGS. 1 and 2, an electronic device according to an embodiment of the disclosure may be a display device 1.

The display device 1 may be a device capable of processing an image signal received from outside and visually displaying a processed image. In FIGS. 1 and 2, the display device 1 is shown to be a television (TV), although not limited thereto. For example, the display device 1 may be implemented as various types, such as a monitor, a portable multimedia device, a portable communication device, etc., and the type of the display device 1 is not limited as long as the display device 1 visually displays images.

In addition, the display device 1 may be a Large Format Display (LFD) that is installed outdoor, such as the roof of a building or a bus stop. Herein, the outdoor is not necessarily limited to outside, and the display device 1 according to an embodiment of the disclosure may be installed at any place where many people come in and out, such as subway stations, shopping malls, movie theaters, places of business, stores, etc., although the place is indoor.

The display device 1 may receive content including a video signal and an audio signal from various content sources, and output video and audio corresponding to the video signal and the audio signal. For example, the display device 1 may receive content data through a broadcasting reception antenna or a wired cable, receive content data from a content reproducing device, or receive content data from a content providing server of a content provider.

The display device 1 may display a screen. More specifically, the display device 1 may include a display panel 10 for displaying an image on a front side.

A plurality of pixels P may be formed in the display panel 10, and a screen displayed on the display panel 10 may be formed by a combination of light emitted from the plurality of pixels. For example, light emitted from the plurality of pixels may be combined like a mosaic to form a screen.

Each of the plurality of pixels may emit light of various brightness levels and various colors. More specifically, each of the plurality of pixels may include sub pixels, and the sub pixels may include a red sub pixel capable of emitting red light, a green sub pixel capable of emitting green light, and a blue sub pixel capable of emitting blue light. Each of the plurality of pixels may emit light having various brightness levels and various colors by a combination of light emitted from the red sub pixel, the green sub pixel, and the blue sub pixel.

The display panel 10 may be a self-emissive display panel such as Organic Light Emitting Diode (OLED) or a non-emissive display panel such as a Liquid Crystal Display (LCD). A kind of the display panel 10 is not limited, and the display device 1 may include various types of the display panel 10.

According to the display panel 10 being a LCD panel, the display panel 10 may include a Thin Film Transistor (TFT) substrate on which TFTs are arranged in a matrix form, a color filter substrate coupled with the TFT substrate in such a way as to be parallel to the TFT substrate, and Liquid Crystal injected between the TFT substrate and the color filter substrate, wherein optical properties of liquid crystal change according to a change in voltage or temperature. Also, a Back Light Unit (BLU) (not shown) may be provided behind the display panel 10.

The back light unit may emit light toward the display panel 10 behind the display panel 10. In this case, the display panel 10 may block or transmit light emitted from the back light unit, although not limited thereto.

However, the display panel 10 may be a self-emissive display panel such as an OLED panel, as described above.

In one side of the display panel 10, a cable (not shown) for transmitting image data to the display panel 10, and a Display Driver Integrated Circuit (DDI) (not shown) for processing digital image data and outputting an analog image signal may be provided.

The display device 1 may include display cases 20, 30, and 40 that support the display panel 10. The display cases 20, 30, and 40 may support front, side, and rear surfaces of the display panel 10.

The display cases 20, 30, and 40 may form an outer appearance of the display device 1, and in the display cases 20, 30, and 40, various components for enabling the display device 1 to display images or perform various functions may be provided. In FIGS. 1 and 2, the case 40 is shown to have a flat plate shape, but the shape of the case 40 is not limited thereto. For example, the case 40 may have a curved plate shape to correspond to the shape of the display panel 10. Alternatively, the case 40 may change between a flat state and a curved state to be applied to a Bendable or Flexible display device 1.

The display cases 20, 30, and 40 may include a top chassis 20 that supports front and side surfaces of the display panel 10. The top chassis 20 may form a bezel positioned toward the front side of the display device 1 to support the front surface of the display panel 10. However, in the case in which the display device 1 is a bezel-less type display device having a very narrow bezel or including no bezel, the top chassis 20 may support only the side surfaces of the display panel 10. Furthermore, in the case in which a bottom chassis 40 supports the side surfaces of the display panel 10, the display device 1 may include no top chassis 20.

The display device 1 may include the bottom chassis 40 that supports a rear side of the display panel 10. The bottom chassis 40 may cover the rear side of the display panel 10, and support various components, such as the back light unit (not shown), a Printed Circuit Board Assembly (PCBA) 50, and the like. The printed circuit board assembly 50 may be a configuration including a Printed Circuit Board (PCB) 51 and various electronic components mounted on the printed circuit board 51, and the printed circuit board assembly 50 will be described in detail, below.

According to the display panel 10 including the top chassis 20, the bottom chassis 40 may be coupled with a rear side of the top chassis 20.

The display device 1 may include a rear cover 30 forming a rear surface of the display device 1. The rear cover 30 may be positioned behind the bottom chassis 40, and cover the bottom chassis 40 and various components (for example, the printed circuit board assembly 50, etc.) mounted on a rear side of the bottom chassis 40.

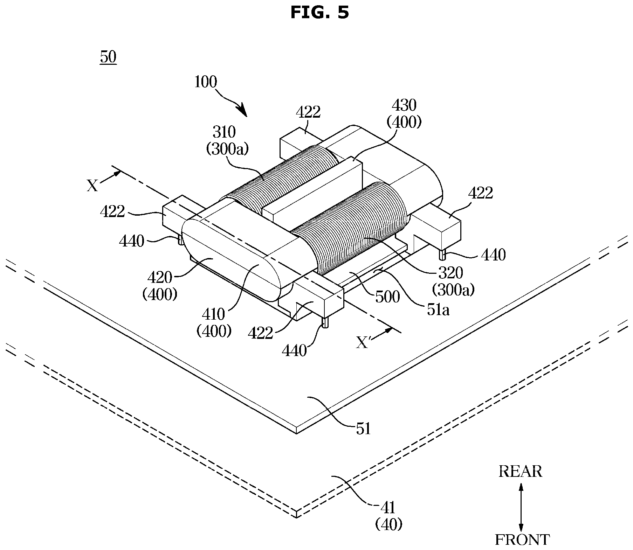

As shown in FIG. 2, the printed circuit board 51 may be mounted on the display cases 20, 30, and 40. In other words, the display cases 20, 30, and 40 may include a board mounting portion 41 (see FIG. 5) on which the printed circuit board 51 is mounted. The printed circuit board 51 may be mounted on the board mounting portion 41, and as a result, the printed circuit board assembly 50 may be mounted on the board mounting portion 41.

More specifically, the printed circuit board 51 may be mounted on the bottom chassis 40. Particularly, the printed circuit board 51 may be mounted on the rear side of the bottom chassis 40. In other words, the board mounting portion 41 may be provided on the rear side of the bottom chassis 40, and the printed circuit board assembly 50 including the printed circuit board 51 may be positioned between the bottom chassis 40 and the rear cover 30, although not limited thereto.

However, the board mounting portion 41 may be provided at various locations of the display cases 20, 30, and 40 where the printed circuit board 51 is stably supportable.

The board mounting portion 41 will be described in detail, below.

Meanwhile, the configuration according to a concept of the disclosure is not limited to being applied to the display device 1 described above, and may be applied to various kinds of electronic devices.

More specifically, the display device 1 according to an embodiment of the disclosure may be referred to as an electronic device in general terms, and the display cases 20, 30, and 40 of the display device 1 may be referred to as a main body of an electronic device in general terms. The main body of the electronic device may be a configuration that forms an outer appearance of the electronic device or accommodates components required to drive the electronic device. Like printed circuit boards 50, 60, and 70 of the display device 1, at least one printed circuit board may also be mounted on the main body of the electronic device. In other words, the main body of the electronic device may be provided with a board mounting portion on which a printed circuit board is mounted.

In other words, descriptions about components of the electronic device according to a concept of the disclosure, such as the board mounting portion, the printed circuit board, the line filer, etc., may be the same as or similar to descriptions about components of the display device 1, such as the board mounting portion 41, the printed circuit boards 50, 60, and 70, a line filter 100, etc.

Accordingly, for convenience of description, the following description about an example according to a concept of the disclosure will be given based on the display device 1 as a kind of an electronic device, and descriptions about other kinds of electronic devices and general descriptions about an electronic device may be omitted.

As described above, the printed circuit board assembly 50 may include the printed circuit board 51 mounted on the board mounting portion 41, and the electronic components mounted on the printed circuit board 51.

The printed circuit board 51 may be formed by printing a circuit line pattern with a conductive material such as copper on an electrically insulating board.

The circuit line pattern on the printed circuit board 51 and the electronic components mounted on the printed circuit board 51 may be provided differently depending on a function, etc. which is provided by the printed circuit board assembly 50.

That is, the printed circuit board assembly 50 may be provided as various kinds of printed circuit board assemblies 50 according to functions and configurations that are provided to drive the display device 1.

For example, the printed circuit board assembly 50 may include a Main Board, a Power Supply Board, and a Source Board.

The main board may include a processor and a power management device for driving the display device 1. The power supply board may supply power for driving the display device 1. The source board may control the display panel 10 of the display device 1.

A plurality of printed circuit board assemblies 50, such as the main board, the power supply board, and the source board, may be positioned independently or combined with each other. The printed circuit board assemblies 50 positioned independently may be electrically connected to each other in order to transmit/receive data, signals, or power to/from each other.

As shown in FIG. 2, the plurality of printed circuit board assemblies 50 may be provided, and each of the plurality of printed circuit board assemblies 50 may be configured with the main board, the power supply board, the source board, etc. The plurality of printed circuit board assemblies 50 may be electrically connected to each other to perform a function for driving the display device 1. However, unlike this, the printed circuit board assemblies 50 may be integrated to perform a function.

Hereinafter, a case in which the printed circuit board assembly 50 is a power supply board will be described as an example.

However, a concept of the disclosure is not limited to the case in which the printed circuit board assembly 50 is configured as a power supply board, and the concept of the disclosure may also be applied to another kind of printed circuit board assembly 50 except for a power supply board.

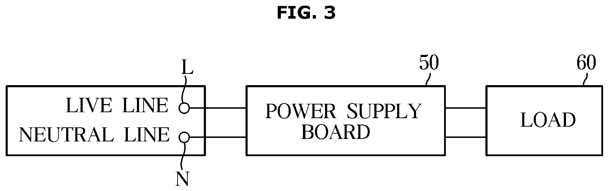

FIG. 3 is a block diagram for schematically describing an operation of a power supply board in a display device according to an embodiment of the disclosure.

An operation in which the power supply board supplies power to the display device according to an embodiment of the disclosure will be described with reference to FIG. 3.

Referring to FIG. 3, a power supply board 50 may be configured to receive power from an external power supply (not shown) and supply the power to the display device 1. The power supply board 50 may include the printed circuit board 51 and various components mounted on the printed circuit board 51 to supply power for driving the display device 1.

The power supply board 50 may be connected to power terminals L and N and electrically connected to an external power source through the power terminals L and N. The external power source may be configured as an alternating current power source, and the power supply board 50 may receive alternating current power through the power terminals L and N. The power terminals L and N may include a live line Live and a neutral line Neutral.

The display device 1 may include a load 60 capable of performing operations or functions by receiving power.

The load 60 may be various components provided to drive the display device 1, and may collectively refer to components that perform various functions by consuming power received from the power supply board 50.

The power supply board 50 may receive power from the external power supply through the power terminals L and N and supply operating power and/or standby power to the load 60.

The power supply board 50 may include a Switched Mode Power Supply (SMPS) board including a switch device that performs on/off switching operations.

The SMPS board, which is a module type power supply board for converting electricity supplied from outside to be usable in various electronic devices, such as a computer, a TV, a wireless communication device, etc., may function to convert commercial power into high-efficiency/high-quality power required by various electronic devices by using switching functions of semiconductor devices and power conversion functions of transformers and supply the power.

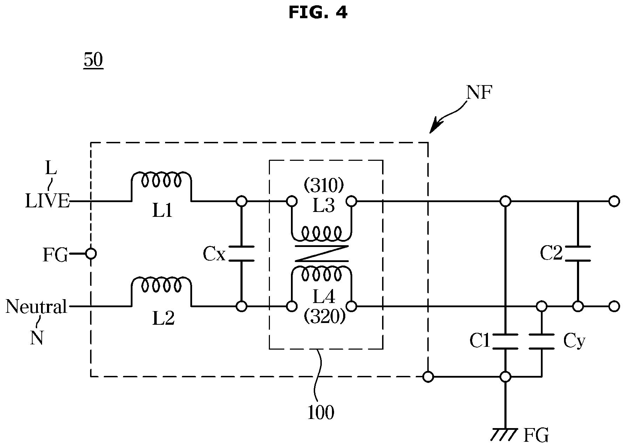

The power supply board 50 may include a Power Converter (not shown) to convert power received from the outside to be supplied to the load 60. The power converter may be provided between a noise filter NF (see FIG. 4) which will be described below and the load 60.

FIG. 4 is a circuit diagram schematically showing a noise filter for reducing current noise in a display device according to an embodiment of the disclosure.

A configuration of the noise filter for reducing current noise in the power supply board 50 of the display device according to an embodiment of the disclosure will be described with reference to FIG. 4

Referring to FIG. 4, the power supply board 50 may include the noise filter NF configured to reduce current noise. The noise filter NF may be mounted on the printed circuit board 51.

The noise filter NF may be connected to the power terminals L and N to receive power. The power terminals L and N connected to the noise filter NF may include the live line L and the neutral line N, as described above.

The noise filter NF may be connected to a frame ground FG. For example, the noise filter NF may be mounted on the printed circuit board 51 and the printed circuit board 51 may be mounted on the display cases 20, 30, and 40, wherein the display cases 20, 30, and 40 may be provided as the frame ground FG.

In the printed circuit board assembly 50 such as the power supply board, noise may be generated while current flows. Types of noise caused by current may include spatial noise transferred into the air and conductive noise transferred through wires, such as power lines, signal lines, ground lines, etc.

Conductive noise may include Normal Mode Noise that is transmitted through wires connected to the power terminals L and N and travels back and forth between the power terminals L and N, and Common Mode Noise that is transmitted between the power terminals (Live, Neutral) and the frame ground terminal FG.

As shown in FIG. 4, the noise filter NF may include first and second Normal mode choke coils L1 and L2, a Line cross capacitor Cx, and first and second Common mode chock coils L3 and L4.

The first normal mode choke coil L1 may be connected to the live line L, and the second normal mode choke coil L2 may be connected to the neutral line N.

The line cross capacitor Cx may be connected between the first and second normal mode choke coils L1 and L2, and the first and second common mode choke coils L3 and L4 may be connected to both terminals of the line cross capacitor Cx.

A plurality of capacitors C1, C2, and Cy may be connected to the first and second common mode choke coils L3 and L4.

Each of the first and second normal mode choke coils L1 and L2 may be wound around an outer side of a Core (not show) to have magnetic flux in one direction. The first and second normal mode choke coils L1 and L2 may be combined with the line cross capacitor Cx to effectively reduce normal mode noise. In this aspect, the first and second normal mode choke coils L1 and L2 may configure a portion of a normal mode noise filter for reducing normal mode noise.

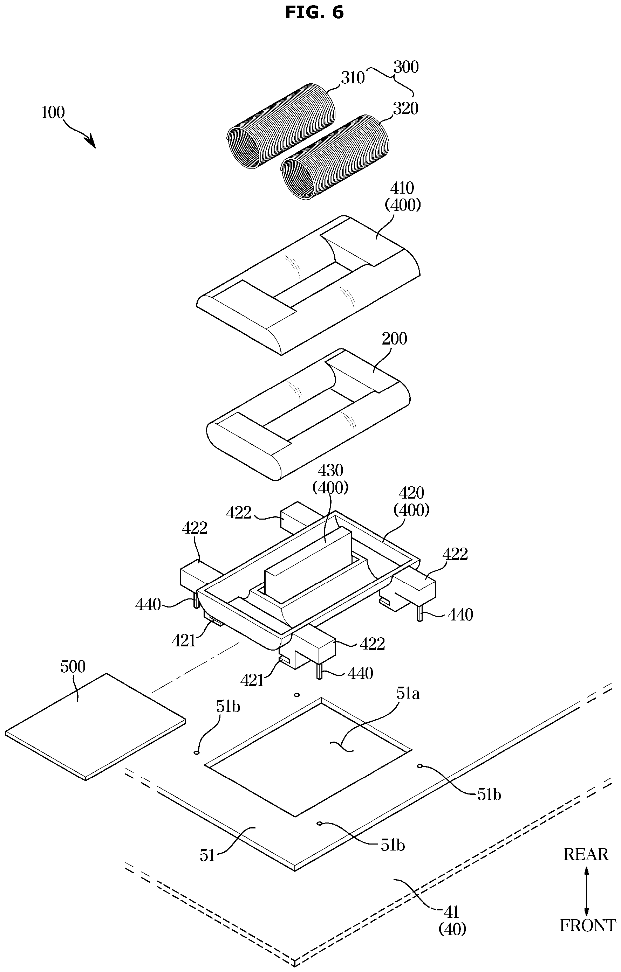

The first and second common mode choke coils L3 and L4 may be wound around an outer side of a core 200 (see FIG. 6) in opposite directions. The first common mode choke coil L3 and the second common mode choke coil L4 may be wound around the same core 200. Accordingly, when common mode noise flows through the first and second common mode choke coils L3 and L4, the first and second common mode choke coils L3 and L4 may form magnetic flux passing in the same direction with respect to the core 200, and the first and second common mode choke coils L3 and L4 may effectively reduce the common mode noise. In this aspect, the first and second common mode choke coils L3 and L4 may configure a portion of a common mode noise filter 100 for reducing common mode noise.

As such, to prevent Electro Magnetic Interference (EMI) caused by current noise, the noise filter NF may be mounted on the printed circuit board 51. Also, the noise filter NF may include the common mode noise filter 100 for suppressing common mode noise and the normal mode noise filter for suppressing normal mode noise.

So far, the configuration and function of the noise filter NF included in the display device 1 according to an embodiment of the disclosure has been described with reference to FIG. 4. However, the above-described embodiment is only an example of a noise filter that may be included in the display device according to a concept of the disclosure, and the concept of the disclosure is not limited thereto.

Hereinafter, for convenience of description, the common mode noise filter 100 is referred to as a line filter. Also, the first common mode choke coil L3 is referred to as a first coil 310, and the second common mode choke coil L4 is referred to as a second coil 320.

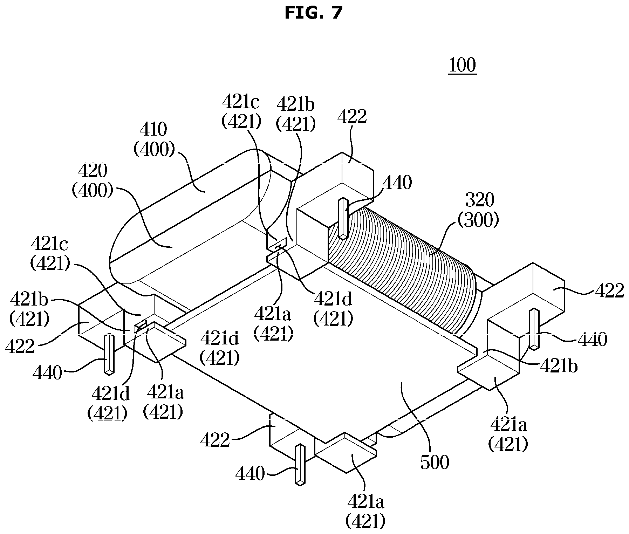

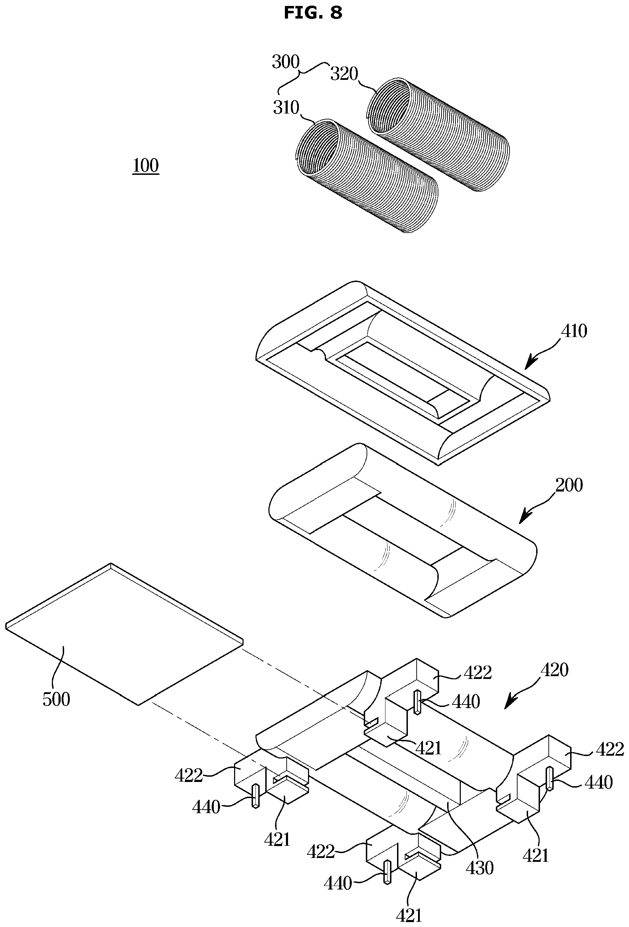

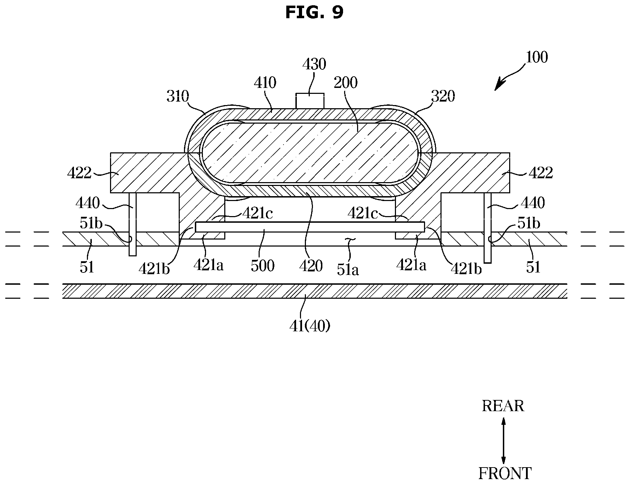

FIG. 5 shows a line filter of a display device according to an embodiment of the disclosure. FIG. 6 is an exploded perspective view of the line filter of FIG. 5. FIG. 7 is a view of the line filter of FIG. 5, shown from below. FIG. 8 is an exploded perspective view of the line filter of FIG. 5, shown from below. FIG. 9 is a cross-sectional view taken along line X-X' of FIG. 5.

Referring to FIGS. 5 to 9, the display device 1 may include the board mounting portion 41 provided in the display cases 20, 30, and 40, and the printed circuit board 51 mounted on the board mounting portion 41. In other words, the display device 1 may include the board mounting portion 41, and the printed circuit board assembly 50 mounted on the board mounting portion 41, wherein the printed circuit board assembly 50 may be, for example, the power supply board 50.

The board mounting portion 41 may be provided in the bottom chassis 40. In other words, the power supply board 50 may be mounted on the bottom chassis 40.

The board mounting portion 41 may be provided in the rear side of the bottom chassis 40, and accordingly, the power supply board 50 may be positioned between the bottom chassis 40 and the rear cover 30. More specifically, the printed circuit board 51 may be mounted on the rear side of the bottom chassis 40, and the electronic components mounted on the printed circuit board 51 may be positioned toward a rear direction of the display device 1 from the printed circuit board 51.

For example, as shown in FIG. 5, electronic components such as the line filter 100 may be mounted on the printed circuit board 51. The electronic components such as the line filter 100 may be mounted on one side of the printed circuit board 51, which is opposite to the bottom chassis 40, that is, one side of the printed circuit board 51 facing the rear cover 30. Like the line filter 100 shown in FIGS. 5 and 6, a board hole 51a may be formed in the printed circuit board 51, and even in the case in which at least one of electronic components is inserted in the board hole 51a or penetrates the printed circuit board 51, the electronic components may be mounted on the printed circuit board 51 from one side of the printed circuit board 51 facing the rear cover 30 toward another side facing the bottom chassis 40.

However, the printed circuit board 51 may be mounted at various locations of the display cases 20, 30, and 40, instead of being mounted on the rear side of the bottom chassis 40, as described above. In other words, the board mounting portion 41 may be provided at various locations of the display cases 20, 30, and 40 where the printed circuit board 51 is stably mounted.

Preferably, the printed circuit board 51 may be spaced a preset distance from at least a part of the board mounting portion 41 for product lifespan, reduction of vibration during operation, and safety. Accordingly, one surface of the printed circuit board 51 facing the board mounting portion 41 may be spaced from at least a part of the board mounting portion 41. In other words, one surface of the printed circuit board 51 facing the bottom chassis 40 may be spaced from at least a portion of the bottom chassis 40.

For example, a Supporter (not shown) for maintaining a separation distance from the board mounting portion 41 may be mounted on the printed circuit board 51. The supporter may have a shape protruding from the printed circuit board 51 toward the board mounting portion 41.

In contrast, the board mounting portion 41 may be provided with a structure (not shown) having a shape protruding toward the printed circuit board 51, and the printed circuit board 51 may be mounted on the board mounting portion 41 by being directly mounted on the structure.

The display device 1 may include the line filter 100 for reducing current noise. The line filter 100 may be mounted on the printed circuit board 51.

The line filter 100 may include the core 200, a core case 400 in which the core 200 is accommodated, and a coil 300 wound around at least a portion of an outer side of the core case 400. Current may flow through the coil 300, and magnetic flux generated by current flowing through the coil 300 may flow along the core 200.

The coil 300 may cause current to flow therethrough according to application of a voltage. For example, the coil 300 may include a conductive material such as copper (Cu), although not limited thereto. However, the coil 300 may include various materials.

The coil 300 may be formed by winding a long and thin wire. The coil 300 may be wound around at least a portion of the outer side of the core case 400 and the core 200. Accordingly, the coil 300 may have a shape forming an internal space and extending in at least one direction.

The coil 300 may be parallel to at least a portion of the core 200. In other words, the coil 300 may extend in a direction that is parallel to at least a portion of the core 200.

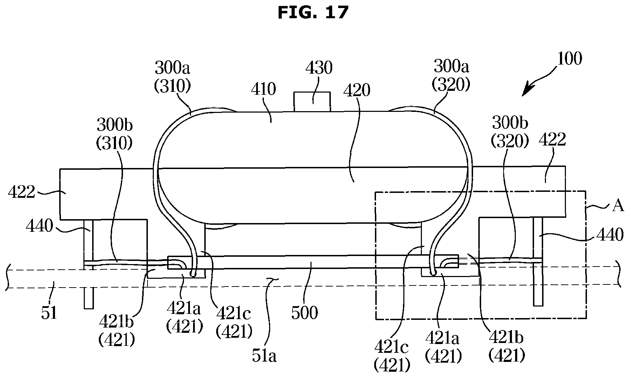

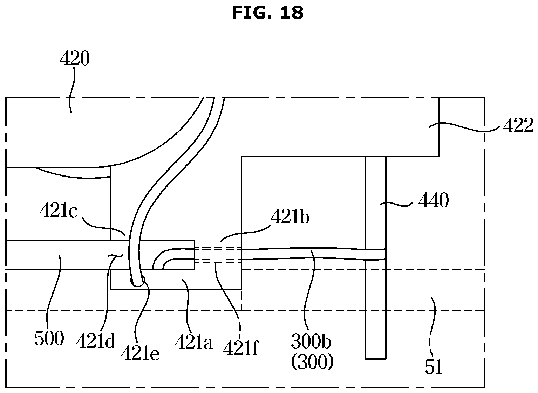

The coil 300 may include a winding portion 300a wound around the outer side of the core case 400, and a connection end 300b (see FIGS. 17 and 18) extending from the winding portion 300a and connected to a connection pin 440.

The winding portion 300a may be parallel to at least a portion of the core 200.

The connection pin 400 may be a component of the line filter 100 fixed to the printed circuit board 51 and include a conductive material. The coil 300 may be electrically connected to the power terminals L and N and the frame ground FG by being connected to the connection pin 440 through the connection end 300b. Furthermore, the coil 300 may generate magnetic flux by current supplied from the power terminals L and N, and generate an induced electromotive force based on an amount of change in current.

The connection pin 400 will be described in detail, below.

The coil 300 may include a first coil 310 and a second coil 320. The first coil 310 and the second coil 320 may be wound around the outer side of the core case 400 and the core 200. The first coil 310 and the second coil 320 may be spaced from each other in such a way as to be opposite to each other on the outer side of the core case 400.

The outer side of the core case 400 and the core 200 around which the first coil 310 is wound may be referred to as a first area, and the outer side of the core case 400 and the core 200 around which the second coil 320 is wound may be referred to as a second area.

The first area and the second area may be provided in the outer side of the core case 400, and may be spaced from each other in such a way as to be opposite to each other.

The first coil 310 may be parallel to the first area, and the second coil 320 may be parallel to the second area.

A separator 430 may be provided between the first area and the second area to insulate the first coil 310 and the second coil 320 from each other, which will be described below.

The first coil 310 and the second coil 320 may be respectively connected to the power terminals L and N, wherein, for example, the first coil 310 may be connected to the live line L and the second coil 320 may be connected to the neutral line N. However, this is only an example, and the second coil 320 may be connected to the live line L while the first coil 310 may be connected to the neutral line N.

The core 200 may include a material having high Permeability. The coil 300 may be wound around the outer side of the core 200, and the core 200 may provide a path along which magnetic flux generated by current flowing through the coil 300 passes.

The core 200 may be formed in an annular shape. More specifically, the core 200 may have a closed loop shape such that magnetic flux generated by current flowing through the coil 300 circulates along the core 200.

The core 200 may be made of a magnetic material composed of an iron compound such as ferrite to have magnetism. Accordingly, magnetic flux generated by current flowing through the coil 300 may more easily circulate along the core 200, and an induced electromotive force may be more efficiently generated according to a change of current. As a result, efficiency of the line filter 100 in reducing current noise may be improved. However, the disclosure is not limited thereto, and the core 200 may include various materials.

The core case 400 may accommodate the core 200. The core 200 may be positioned inside the core case 400.

The core case 400 may include a core cover 410 and a core base 420. The core base 420 may cover one side of the core 200 and be coupled with the printed circuit board 51. The core cover 410 may cover another side of the core 200 and be coupled with the core base 420.

The core base 420 may cover one side of the core 200 facing the printed circuit board 51, and the core cover 410 may cover another side of the core 200 which is opposite to the printed circuit board 51.

The core cover 410 may be formed to have a concave inner side facing the core 200 and the core base 420. Alternatively, the core base 420 may be formed to have a concave inner side facing the core 200 and the core cover 410. Accordingly, an accommodating space where the core 200 is accommodated may be formed between the core cover 410 and the core base 420.

However, the above-described configuration of the core cover 410 and the core base 420 is only an example of a configuration constituting the core case 400 of the line filter 100 according to an embodiment of the disclosure, and the core case 400 may include various configurations capable of accommodating the core 200.

The coil 300 may be wound around at least a portion of the outer side of the core case 400. More specifically, the coil 300 may be wound along the core 200, on the outer side of the core case 400. As described above, the first coil 310 may be wound around the first area of the outer side of the core case 400 and the core 200, and the second coil 320 may be wound around the second area of the outer side of the core case 400 and the core 200, the second area being opposite to the first area.

In other words, the coil 300 may be wound on the outer side of the core case 400 surrounding the core 200, instead of being wound directly on the outer side of the core 200.

The core 200 and the core case 400 in which the core 200 is accommodated may be referred to as a core assembly. The coil 300 may be wound around an outer side of the core assembly 200 and 400. The first coil 310 may be wound around the first area on the outer side of the core assembly 200 and 400, and the second coil 320 may be wound around the second area on the outer side of the core assembly 200 and 400, the second area being opposite to the first area.

The core case 400 may be formed to have a shape corresponding to the core 200. For example, as shown in FIGS. 5 to 9, the core case 400 may be formed to have a substantially annular shape in correspondence with the core 200 having an annular shape. That is, the core assembly 200 and 400 may have a substantially annular shape.

Each of the core cover 410 and the core base 420 may be formed to have a substantially annular shape.

The first coil 310 may be wound along a portion of edges of the core case 400 and the core 200 each having an annular shape. Likewise, the second coil 320 may be wound along another portion of the edges of the core case 400 and the core 200 each having an annular shape, the other portion being opposite to the one portion.

In other words, the first coil 310 may be wound along one portion of the edges of the core assembly 200 and 400 having an annular shape, and the second coil 320 may be wound along another portion of the edges of the core assembly 200 and 400 having an annular shape, the other portion being opposite to the one portion.

Because each of the first coil 310 and the second coil 320 is connected to the live line L or the neutral line N and thus input current or output current may flow through the first coil 310 and the second coil 320, the first coil 310 and the second coil 320 may need to be insulated from each other. Accordingly, the first coil 310 and the second coil 320 may need to be spaced a preset distance from each other.

The line filter 100 may further include the separator 430 for insulating the first coil 310 and the second coil 320 from each other.

The separator 430 may be formed to penetrate an inside of the core assembly 200 and 400. More specifically, the separator 430 may be formed in the core assembly 200 and 400 having an annular shape to penetrate an inside of the annular shape. In other words, the separator 430 may be formed to penetrate an inside of the core case 400. In other words, the separator 430 may be provided to penetrate both insides of the core cover 410 and the core base 420. That is, the separator 430 may be positioned to penetrate the core assembly 200 and 400 between the first area and the second area of the outer side of the core assembly 200 and 400.

Accordingly, the separator 430 may be positioned between the first coil 310 and the second coil 320 to ensure a separation distance between the first coil 310 and the second coil 320 while insulating the first coil 310 and the second coil 320 from each other.

Because the line filter 100 includes the separator 430, insulation between the first coil 310 and the second coil 320 may be possible although a separation distance between the first coil 310 and the second coil 320 is reduced. Accordingly, the size of the line filter 100 may be miniaturized, and manufacturing cost may be reduced.

The separator 430 may be coupled with at least a portion of the core case 400. For example, as shown in FIGS. 5 to 9, the separator 430 may be coupled with at least a portion of the core case 400 adjacent to the board mounting portion 41. That is, the separator 430 may be coupled with the core base 420 and extend from the core base 420 toward the core cover 410.

More specifically, the separator 430 may be integrated into at least a portion of the core case 400. For example, as shown in FIGS. 5 to 9, the separator 430 may be integrated into the at least a portion of the core case 400 facing the board mounting portion 41. That is, the separator 430 may be integrated into the core base 420.

Because the separator 430 is integrated into a portion of the core case 400, the line filter 100 including the core case 400 and the separator 430 may be simplified in structure, and manufacturing cost may be reduced. That is, productivity of the line filter 100 may be improved.

Furthermore, a fixing portion 422 of the core case 400 may be injection-molded integrally with the core base 420 or the core cover 410, which will be described below, and in the case in which the separator 430 is also integrated into a portion of the core case 400, the core case 400 may be configured with a very small number of components, for example, only two components of the core cover 410 and the core base 420, which may significantly improve productivity of the core case 400.

However, the disclosure is not limited thereto, and the separator 430 may be formed variously. For example, the separator 430 may be coupled to the core cover 410 or integrated into the core cover 410. In this case, the separator 430 may extend from the core cover 410 toward the core base 420.

Alternatively, the separator 430 may be provided as a separate component from the core case 400, without being integrated into at least a portion of the core case 400.

The core assembly 200 and 400 may be fixed to the printed circuit board 51. The core case 400 may support the core 200 and the coil 300, and be coupled to the connection pin 440 to be fixed to the printed circuit board 51.

The connection pin 440 may be fixed to the printed circuit board 51. For example, as shown in FIGS. 5 to 9, a connection pin hole 51b may be formed in the printed circuit board 51, and the connection pin 440 may be inserted in the connection pin hole 51b. The connection pin 440 inserted in the connection pin hole 51b may be fixed to the printed circuit board 51 by soldering, although not limited thereto. However, the connection pin 440 may be fixed to the printed circuit board 51 by various methods such as being soldered and fixed directly on one surface of the printed circuit board 51 facing the rear cover 30.

A plurality of connection pins 440 may be provided, and each of the plurality of connection pins 440 may be connected to the live line L or the neutral line N. For example, the connection pin 440 connected to the first coil 310 may be connected to the live line L, and the connection pin 440 connected to the second coil 320 may be connected to the neutral line N. Also, the connection pin 440 may be connected to the frame ground FG. The connection pin 440 may be connected to the power terminals L and N and the frame ground FG through a circuit line pattern of the printed circuit board 51.

The connection pin 440 may be coupled to the core case 400. The core case 400 may include the fixing portion 422 for fixing the connection pin 440 fixed to the printed circuit board 51 to the core case 400.

The connection pin 440 may be coupled to the fixing portion 422. At least one end of the connection pin 440 may be positioned outside the fixing portion 422 to be fixed to the printed circuit board 51. For example, the connection pin 440 may penetrate the fixing portion 422, and at least one end of the connection pin 440 may extend from the fixing portion 422 toward the printed circuit board 51.

The fixing portion 422 may extend outward from the core case 400. For example, the fixing portion 422 may extend outward from an edge of the core base 420. The fixing portion 422 may extend outward from the core base 420 in such a way as to be parallel to the printed circuit board 51, although not limited thereto.

However, the fixing portion 422 may have various shapes for coupling the connection pin 440 to the core case 400. For example, the fixing portion 422 may have a shape extending from the core base 420 toward the printed circuit board 51, and in this case, the fixing portion 422 may be positioned between the core base 420 and the printed circuit board 51. Alternatively, the fixing portion 422 may extend outward from an edge of the core case 400.

The fixing portion 422 may be injection-molded integrally with the core base 420 or the core cover 410, although not limited thereto. However, the fixing portion 422 may be formed separately from the core cover 410 or the core base 420.

A plurality of fixing portions 422 may be provided to correspond to the number of the connection pins 440, although not limited thereto. However, the number of the fixing portions 422 may be various.

The printed circuit board 51 may include a board hole 51a provided at a location where the line filter 100 is mounted. The line filter 100 may be fixed to the printed circuit board 51 by the connection pin 440, and simultaneously, at least a portion of the line filter 100 may be inserted in the board hole 51a to thereby be mounted on the printed circuit board 51.

The board hole 51a may be formed to correspond to the core case 400. Accordingly, at least a portion of the core case 400 may be inserted in the board hole 51a.

At least a portion of a shield support portion 421 of the core case 400, which will be described below, may be inserted into the board hole 51a.

The connection pin hole 51b may be formed outside the board hole 51a. The connection pin 440 may be fixed to the printed circuit board 51 outside the board hole 51a. The fixing portion 422 may extend outward from the board hole 51a.

As at least a portion of the line filter 100 is inserted into the board hole 51a, a protruding length of the line filter 100 from the printed circuit board 51 may be reduced, and, as a result, a size of the display device 1 may be miniaturized, although not limited thereto.

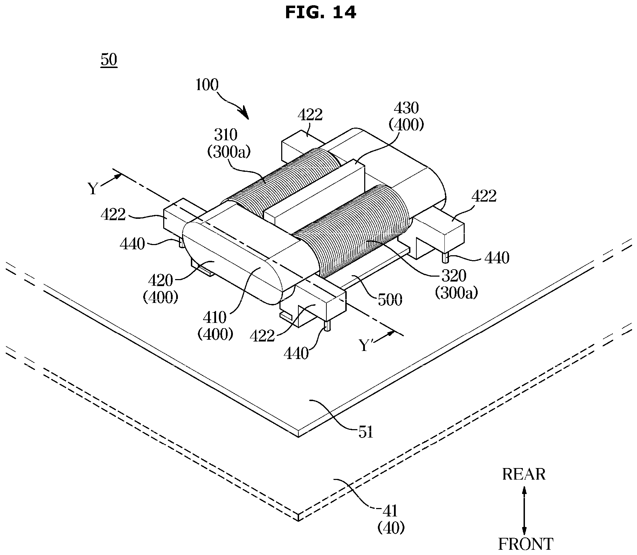

However, the line filter 100 may be mounted on the printed circuit board 51 in various ways. For example, as shown in FIGS. 14 to 16, no separate board hole 51a may be formed in the printed circuit board 51, and the line filter 100 may be rested on one surface of the printed circuit board 51 or spaced a preset distance from one surface of the printed circuit board 51.

To miniaturize the size of the display device 1, it may be preferable to reduce a distance between the board mounting portion 41 and the printed circuit board 51 and a distance between the board mounting portion 41 and the line filter 100.

However, in this case, while the line filter 100 operates, an electric field or a magnetic field may be generated, and the electric field or the magnetic field may influence the board mounting portion 41 positioned adjacent to the line filter 100. For example, as an electric field or a magnetic field generated while the line filter 100 operates influences the board mounting portion 41, several components of the display device 1, such as the board mounting portion 41, the line filter 100, and the printed circuit board 51, may vibrate. When the components of the display device 1 vibrate, the vibration may cause noise or damage the components, which may shorten product lifespan. Particularly, a component such as the bottom chassis 40 including a metal material, in which the board mounting portion 41 is provided, may cause a more important problem.

To overcome such a problem, the line filter 100 may include a shielding member 500 for shielding an electric field or a magnetic field.

The shielding member 500 may be positioned between the core 200 and the board mounting portion 41 to reduce an electromagnetic force that may be generated between the core 200 and the board mounting portion 41. In the case in which the board mounting portion 41 is provided on the bottom chassis 40, the shielding member 500 may be positioned between the core 200 and the bottom chassis 40.

The shielding member 500 may include a magnetic material to shield an electric field or a magnetic field. For example, the shielding member 500 may include a magnetic material made of an iron compound such as ferrite, although not limited thereto. However, the shielding member 500 may include various materials configured to shield an electric field or a magnetic field.

The shielding member 500 may extend in parallel to the board mounting portion 41. According to the board mounting portion 41 being provided on the bottom chassis 40, the shielding member 500 may extend in parallel to the bottom chassis 40. The shielding member 500 may cover one side of the core assembly 200 and 400 facing the board mounting portion 41. Also, the shielding member 500 may cover one side of the coil 300 facing the board mounting portion 41.

The shielding member 500 may be formed in a substantially flat plate shape extending in parallel to the board mounting portion 41. Accordingly, the size of the display device 1 may be further miniaturized, and a weight and manufacturing cost of the line filter 100 may be reduced.

However, the above-described configuration of the shielding member 500 is only an example of the shielding member 500 included in the line filter 100 in the display device 1 according to an embodiment of the disclosure. According to a concept of the disclosure, the shielding member is not limited to that described above and may be configured in various ways.

The core case 400 may include the shield support portion 421 that supports the shielding member 500. The shield support portion 421 may enable the shielding member 500 to be positioned between the core 200 and the board mounting portion 41 and supported by the core case 400.

The shield support portion 421 may support one surface of the shielding member 500 facing the board mounting portion 41. In other words, the shield support portion 421 may support one surface of the shielding member 500, which is opposite to another side facing the core 200. According to the board mounting portion 41 being provided on the bottom chassis 40, the shield support portion 421 may support one surface of the shield member 500 facing the bottom chassis 40.

In the line filter 100, the shielding member 500 may be positioned in a direction facing the board mounting portion 41 with respect to the core 200, a portion of the core case 400 covering the core 200, and the coil 300. Accordingly, in order to prevent the shielding member 500 from being separated from the line filter 100 toward the board mounting portion 41, it may be preferable to support one surface of the shielding member 500 facing the board mounting portion 41. In the case in which one side of the shielding member 500 facing the board mounting portion 41 completely opens even though components of the line filter 100, such as the core assembly 200 and 400, are positioned on another side of the shielding member 400, which is opposite to the board mounting portion 41, the shielding member 500 may be separated from the line filter 100. This may occur likewise even when one surface of the shielding member 500, which is opposite to the board mounting portion 41, is attached to the core case 400, or when a structure (not shown) of the shielding member 500 protruding in a direction that is opposite to the board mounting portion 41 is inserted in and coupled to the core case 400. In other words, because the shield support portion 421 supports one surface of the shielding member 500 facing the board mounting portion 41, the shielding member 500 may be more stably supported by the core case 400.

The shield support portion 421 may support the shielding member 500 while spacing the shielding member 500 from the coil 300.

The shield support portion 421 may extend in parallel to the shielding member 500 and the board mounting portion 41. In other words, the shield support portion 421 may extend along the one surface of the shielding member 500 facing the board mounting portion 41. Accordingly, the shield support portion 421 may more stably support the shielding member 500.

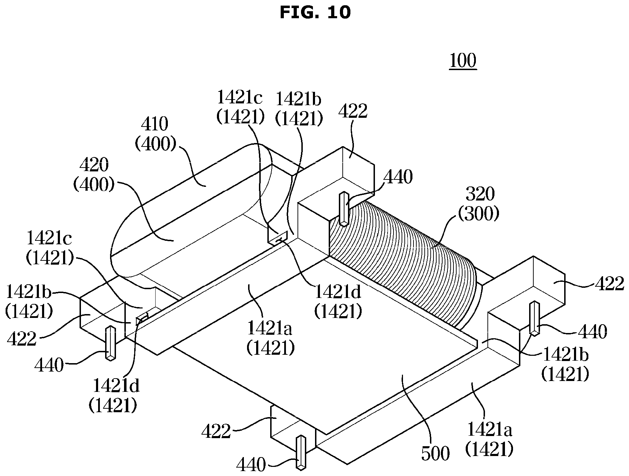

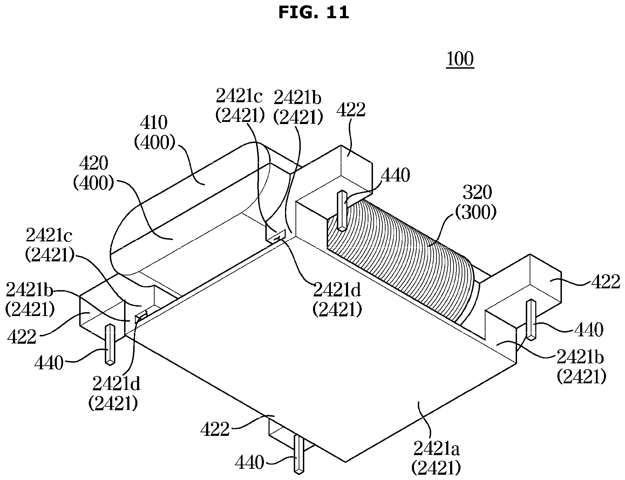

However, a degree by which the shield support portion 421 extends in parallel to the shielding member 500 and the board mounting portion 41 may be various. For example, the shield support portion 421 may extend by a degree of the embodiment shown in FIGS. 5 to 9, by a degree of an embodiment (a shield support portion 1421) shown in FIG. 10, or by a degree of an embodiment (a shield support portion 2421) shown in FIG. 11. Alternatively, the shield support portion according to a concept of the disclosure may extend by a degree that is different from the degrees by which the shield support portions 421, 1421, and 2421 of the embodiments shown in FIGS. 5 to 11 extend.

As shown in FIGS. 5 to 9, the shield support portion 421 may not cover an entire of the one surface of the shielding member 500 facing the board mounting portion 41. In other words, the shield support portion 421 may support a portion of the one surface of the shielding member 500 facing the board mounting portion 41, and another portion of the one surface of the shielding member 500 facing the board mounting portion 41 may open toward the board mounting portion 41. A weight and manufacturing cost of the line filter 100 may be reduced.

A plurality of shield support portions 421 may be provided. The plurality of shield support portions 421 may be spaced from each other. Accordingly, a portion of the shielding member 500 not supported by the plurality of shield support portions 421 may open toward the board mounting portion 41.

The plurality of shield support portions 421 spaced from each other may be positioned in parallel to an extension direction of the coil 300. Alternatively, the plurality of shield support portions 421 spaced from each other may be positioned in parallel to an extension direction of the core 200, although not limited thereto.

However, a single shield support portion 421 may be provided.

Because the shielding member 500 is positioned between the core 200 and the board mounting portion 41, the shield support portion 421 may be formed at a portion of the core case 400 facing the board mounting portion 41. For example, the shield support portion 421 may be provided in the core base 420, and that is, the shield support portion 421 may be a component included in the core base 420. In other words, the one surface of the shielding member 500 facing the board mounting portion 41 may be supported by the core base 420.

However, unlike this, the shield support portion 421 may be included in the core cover 410, and may be a component extending from a portion of the core case 400 toward the core base 420.

The shield support portion 421 may be positioned between the separator 430 and the board mounting portion 41. Accordingly, the shielding member 500 may be positioned between the separator 430 and the board mounting portion 41, and the shielding member 500 may be supported by the shield support portion 421 without being interfered by the separator 430.

The shield support portion 421 may extend from the fixing portion 422. More specifically, the shield support portion 421 may be bent from the fixing portion 422 and extend toward the board mounting portion 41, although not limited thereto. However, the shield support portion 421 may be formed to be distinct from the fixing portion 422.

The core 200 may extend in parallel to the board mounting portion 41, and correspondingly, the coil 300 may be wound around the core case 400 in such a way as to extend in parallel to the board mounting portion 41. According to the board mounting portion 41 being provided on the bottom chassis 40, the core 200 and the coil 300 may extend in parallel to the bottom chassis 40.

According to the core 200 and the coil 300 extending in parallel to the board mounting portion 41, the length of the line filter 100 protruding from the printed circuit board 51 may be reduced compared to the case in which the core 200 and the coil 300 extend in a direction that is orthogonal to an extension direction of the board mounting portion 41. Accordingly, the size of the display device 1 may be miniaturized.

In this case, the shielding member 500 may extend in parallel to the core 200 and the coil 300. Also, the shield support portion 421 may extend in parallel to the core 200 and the coil 300, although not limited thereto.

However, the core 200 and the coil 300 may not extend in parallel to the board mounting portion 41.

The core 200 and the coil 300 may extend in at least one direction, and the extension direction of the core 200 and the coil 300 may be different from the extension direction of the board mounting portion 41. In this case, the shielding member 500 may be positioned between the core 200 and the board mounting portion 41, and furthermore, the shielding member 500 and the shield support portion 421 may extend in parallel to the board mounting portion 41. The shielding member 500 may extend in a direction that is different from the extension direction of the core 200 and the coil 300, and the shield support portion 421 may also extend in a direction that is different from the extension direction of the core 200 and the coil 300.

According to the line filter 100 being mounted on the printed circuit board 51 such that at least a portion of the line filter 100 is inserted in the board hole 51a, at least a portion of the shield support portion 421 may be inserted in the board hole 51a.

For example, as shown in FIG. 9, at least a portion of the shield support portion 421 may be inserted in the board hole 51a. Alternatively, an entire of the shield support portion 421 may penetrate the board hole 51a. Accordingly, the line filter 100 may be positioned in closer contact with the printed circuit board 51, the length of the line filter 100 protruding from the printed circuit board 51 may be reduced, and the size of the display device 1 may be miniaturized, although not limited thereto.

However, the shield support portion 421 may not be inserted in the board hole 51a.

Hereinafter, a shape of the shield support portion 421 will be described in more detail.

The shield support portion 421 may include a first support portion 421a facing the one surface of the shielding member 500 facing the board mounting portion 41, and a second support portion 421b supporting an outer edge of the shielding member 500. The outer edge of the shielding member 500 supported by the second support portion 421b may be bent from the one surface of the shielding member 500 supported by the first support portion 421a. In other words, the second support portion 421b may support a side surface of the shielding member 500 positioned between the one surface of the shielding member 500 supported by the first support portion 421a and another surface of the shielding member 500 which is opposite to the one surface.

Because the one surface of the shielding member 500 facing the board mounting portion 41 is supported by the first support portion 421a and simultaneously, the outer edge is supported by the second support portion 421b, the shielding member 500 may be more stably supported by the shield support portion 421.

The second support portion 421a may be bent at and extend from one end of the first support portion 421a. For example, the first support portion 421a and the second support portion 421b may extend in directions that are orthogonal to each other, although not limited thereto. However, the second support portion 421b may be connected to another portion of the first support portion 421a, instead of any end of the first support portion 421a, and may extend in another direction that is different from an extension direction of the first support portion 421a.

The shield support portion 421 may include a third support portion 421c that faces the first support portion 421a and supports another surface of the shielding member 500, which is opposite to the one surface of the shielding member 500 facing the board mounting portion 41. Because the one surface of the shielding member 500 facing the board mounting portion 41 is supported by the first support portion 421a and simultaneously, another surface of the shielding member 500 facing the core 200 is supported by the third support portion 421c, the shielding member 500 may be more stably supported. In addition, the third support portion 421c may be positioned between the shielding member 500 and the winding portion 300a of the coil 300 to space the shielding member 500 from the coil 300.

The second support portion 421b may connect the first support portion 421a to the third support portion 421c. In other words, the second support portion 421b may be connected to both the first support portion 421a and the third support portion 421c.

The second support portion 421b may extend from one end of the third support portion 421c, and extend in a direction that is different from an extension direction of the third support portion 421c. For example, the second support portion 421b and the third support portion 421c may extend in directions that are orthogonal to each other, although not limited thereto.

However, the first support portion 421a, the second support portion 421b, and the third support portion 421c may be formed variously. For example, the second support portion 421b may be connected to the first support portion 421a, without being connected to the third support portion 421c.

The shield support portion 421 may further include a groove 421d formed between the first support portion 421a, the second support portion 421b, and the third support portion 421c. The shielding member 500 may be inserted in the groove 421d and supported.

According to the shield support portion 421 being provided in the core base 420, the groove 421d may be formed in the core base 420. In other words, the shielding member 500 may be inserted in the core base 420 such that the one surface of the shielding member 500 facing the board mounting portion 41 is supported by the core base 420.

The shielding member 500 may be insertable into the groove 421d in parallel to the board mounting portion 41. For example, at least an end of the groove 421d in parallel to the board mounting portion 41 may open, and the groove 421d may extend in parallel to the board mounting portion 41.

In other words, according to the board mounting portion 41 being provided on the bottom chassis 40, the groove 421d may extend in parallel to the bottom chassis 40, and the shielding member 500 may be inserted into the groove 421d in parallel to the bottom chassis 40.

Referring to FIGS. 5 to 9, the groove 421d is shown to be formed such that the shielding member 500 is insertable in parallel to the extension direction of the coil 300. However, unlike this, the groove 421d may be formed such that the shielding member 500 is insertable in a direction that is different from the extension direction of the coil 300, for example, in a direction that is orthogonal to the extension direction of the coil 300.

Accordingly, in a process of manufacturing the line filter 100, the shielding member 500 may be easily inserted into the groove 421d, and manufacturing efficiency of the line filter 100 may be improved.

However, the disclosure is not limited thereto, and the shielding member 500 may be inserted into the groove 421d in various manners.

The above-described shape of the shield support portion 421 may be only an exemplary shape of the shield support portion according to a concept of the disclosure, and the shield support portion according to a concept of the disclosure may be formed to have various shapes configured to support the one surface of the shielding member facing the board mounting portion.

By the above-described configuration, the display device 1 according to a concept of the disclosure may reduce current noise by including the line filter 100, and the line filter 100 may shield an electric field or a magnetic field caused by an operation of the line filter 100 by including the shielding member 500. Accordingly, vibration and noise caused by an electric field or a magnetic field generated while the line filter 100 operates may be reduced, and a distance between the line filter 100 and the board mounting portion 41 may be reduced, which may miniaturize the size of the display device 1.

In addition, the core case 400 which accommodates the core 200 of the line filter 100 and around which the coil 300 is wound may include the shield support portion 421 to stably support the shielding member 500 together with the shield support portion 421, which may simplify the structure of the core case 400 and reduce manufacturing cost. Also, at least a portion of the core case 400 may be integrated into the separator 430 that insulates the first coil 310 from the second coil 320, which may further simplify the structure of the line filter 100 and further improve productivity.

FIG. 10 shows a line filter of a display device according to another embodiment of the disclosure, wherein the line filter has a modified shape of a shield support portion.

A line filter of a display device according to another embodiment of the disclosure will be described with reference to FIG. 10. In the following descriptions about the embodiment shown in FIG. 10, like components as those shown in FIGS. 1 to 9 are assigned like reference numerals, and descriptions thereof may be omitted.

Referring to FIG. 10, the core case 400 of the line filter 100 may include the shield support portion 1421 that supports the one surface of the shielding member 500 facing the board mounting portion 41.

The shield support portion 1421 may extend along at least one side on the one surface of the shielding member 500 facing the board mounting portion 41. More specifically, for example, as shown in FIG. 10, according to the one surface of the shielding member 500 facing the board mounting portion 41 having a substantially polygonal shape, the shield support portion 1421 may extend along at least one side of the polygon.

A plurality of shield support portions 421 may be provided, and the plurality of shield support portions 1421 may be spaced from each other. The plurality of shield support portions 1421 may be opposite to each other. The plurality of shield support portions 1421 may extend in parallel to each other.

The shield support portion 1421 may include a first support portion 1421a facing the one surface of the shielding member 500 facing the board mounting portion 41, and a second support portion 1421b supporting the outer edge of the shielding member 500. The outer edge of the shielding member 500 supported by the second support portion 1421b may be bent from the one surface of the shielding member 500 supported by the first support portion 1421a. In other words, the second support portion 1421b may support a side surface of the shielding member 500 positioned between the one surface of the shielding member 500 supported by the first support portion 1421a and another surface of the shielding member 500 which is opposite to the one surface.

The second support portion 1421b may be bent at and extend from one end of the first support portion 1421a. For example, the first support portion 1421a and the second support portion 1421b may extend in directions that are orthogonal to each other, although not limited thereto. However, the second support portion 1421b may be connected to another portion of the first support portion 1421a, instead of any end of the first support portion 1421a, and extend in a direction that is different from an extension direction of the first support portion 1421a.

The first support portion 1421a may connect a plurality of second support portions 1421b positioned to be opposite to each other. For example, as shown in FIG. 10, the first support portion 1421a may connect the second support portions 1421b which are positioned to be adjacent to each other and opposite to each other. In other words, the plurality of second support portions 1421b which are opposite to each other may be respectively connected to both ends of the first support portion 1421a.

In FIG. 10, the first support portion 1421a is shown to extend in a direction that is different from the extension direction of the coil 300 or in parallel to a direction in which the first coil 310 faces the second coil 320. However, a shape of the first support portion 1421a is not limited thereto. The first support portion 1421a may extend in parallel to the extension direction of the coil 300.

The shield support portion 1421 may include a third support portion 1421c which is opposite to the first support portion 1421 and supports the other surface of the shielding member 500 which is opposite to the one surface of the shielding member 500 facing the board mounting portion 41.

The second support portion 1421b may connect the first support portion 1421a to the third support portion 1421c. In other words, the second support portion 1421b may be connected to both the first support portion 1421a and the third support portion 1421c.

The second support portion 1421b may extend from one end of the third support portion 1421c and extend in a direction that is different from an extension direction of the third support portion 1421c. For example, the second support portion 1421b and the third support portion 1421c may extend in directions that are orthogonal to each other, although not limited thereto.

However, the first support portion 1421a, the second support portion 1421b, and the third support portion 1421c may be formed variously. For example, the second support portion 1421b may be connected to the first support portion 1421a, without being connected to the third support portion 1421c.

The shield support portion 1421 may further include a groove 1421d formed between the first support portion1421a, the second support portion 1421b, and the third support portion 1421c. The shielding member 500 may be inserted in the groove 1421d and supported.

The shielding member 500 may be insertable into the groove 1421d in parallel to the board mounting portion 41. For example, at least one end of the groove 1421d in a direction that is parallel to the board mounting portion 41 may open, and the groove 1421d may extend in parallel to the board mounting portion 41.

Referring to FIG. 10, the groove 1421d is shown to be formed such that the shielding member 500 is insertable in parallel to the extension direction of the coil 300. However, the groove 1421d may be formed such that the shielding member 500 is insertable in a direction which is different from the extension direction of the coil 300, for example, in a direction which is orthogonal to the extension direction of the coil 300.

FIG. 11 shows a line filter of a display device according to still another embodiment of the disclosure, wherein the line filter has a modified shape of a shield support portion.

A line filter of a display device according to another embodiment of the disclosure will be described with reference to FIG. 11. In the following descriptions about the embodiment shown in FIG. 11, like components as those shown in FIGS. 1 to 9 are assigned like reference numerals, and descriptions thereof may be omitted.

Referring to FIG. 11, the core case 400 of the line filter 100 may include a shield support portion 2421 that supports the one surface of the shielding member 500 facing the board mounting portion 41.

The shield support portion 2421 may cover an entire of the one surface of the shielding member 500 facing the board mounting portion 41. For example, as shown in FIG. 11, the shield support portion 2421 may have a shape corresponding to the shielding member 500, and include a substantially flat plate shape.

The shield support portion 2421 may include a first support portion 2421a that faces the one surface of the shielding member 500 facing the board mounting portion 41, and a second support portion 2421b that supports an outer edge of the shielding member 500. The outer edge of the shielding member 500 supported by the second support portion 2421b may be bent from the one surface of the shielding member 500 supported by the first support portion 2421a. In other words, the second support portion 2421b may support a side surface of the shielding member 500 positioned between the one surface of the shielding member 500 supported by the first support portion 2421a and another surface of the shielding member 500 which is opposite to the one surface.

The second support portion 2421b may be bent at and extend from one end of the first support portion 2421a. For example, the first support portion 2421a and the second support portion 2421b may extend in directions that are orthogonal to each other, although not limited thereto. However, the second support portion 2421b may be connected to another part of the first support portion 2421a, instead of any end of the first support portion 2421a, and extend in a direction that is different from the extension direction of the first support portion 2421a.

The first support portion 2421a may connect a plurality of second support portions 2421b. For example, as shown in FIG. 11, the first support portion 2421a may connect all of the plurality of second support portions 2421b to each other.

The shield support portion 2421 may include a third support portion 2421c that faces the first support portion 2421 and supports another surface of the shielding member 500, which is opposite to the one surface of the shielding member 500 facing the board mounting portion 41.

The second support portion 2421b may connect the first support portion 2421a to the third support portion 2421c. In other words, the second support portion 2421b may be connected to both the first support portion 2421a and the third support portion 2421c.

The second support portion 2421b may extend from one end of the third support portion 2421c, and extend in a direction that is different from an extension direction of the third support portion 2421c. For example, the second support portion 2421b and the third support portion 2421c may extend in directions that are orthogonal to each other, although not limited thereto.

However, the first support portion 2421a, the second support portion 2421b, and the third support portion 3421c may be formed variously. For example, the second support portion 2421b may be connected to the first support portion 2421a, without being connected to the third support portion 2421c.

The shield support portion 2421 may further include a groove 2421d formed between the first support portion 2421a, the second support portion 2421b, and the third support portion 2421c. The shielding member 500 may be inserted in the groove 2421d and supported.

The shielding member 500 may be insertable into the groove 2421d in parallel to the board mounting portion 41. For example, at least one end of the groove 2421d in a direction which is parallel to the board mounting portion 41 may open, and the groove 2421d may extend in parallel to the board mounting portion 41.

Referring to FIG. 11, the groove 2421d is shown to be formed such that the shielding member 500 is insertable in parallel to the extension direction of the coil 300. However, unlike this, the groove 2421d may be formed such that the shielding member 500 is insertable in a direction that is different from the extension direction of the coil 300, for example, in a direction that is orthogonal to the extension direction of the coil 300.

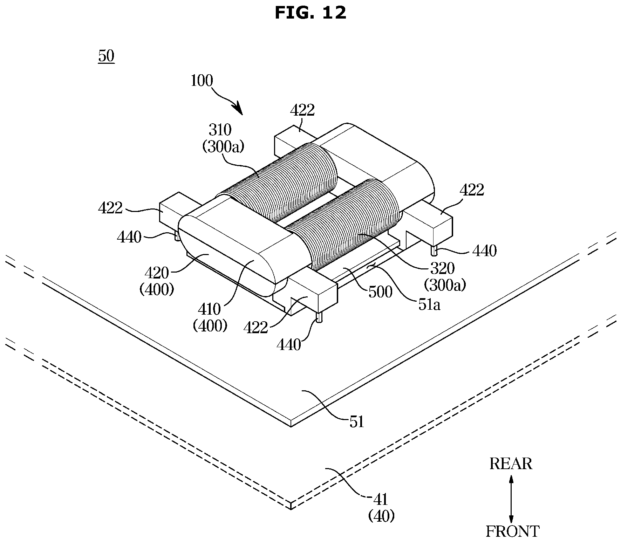

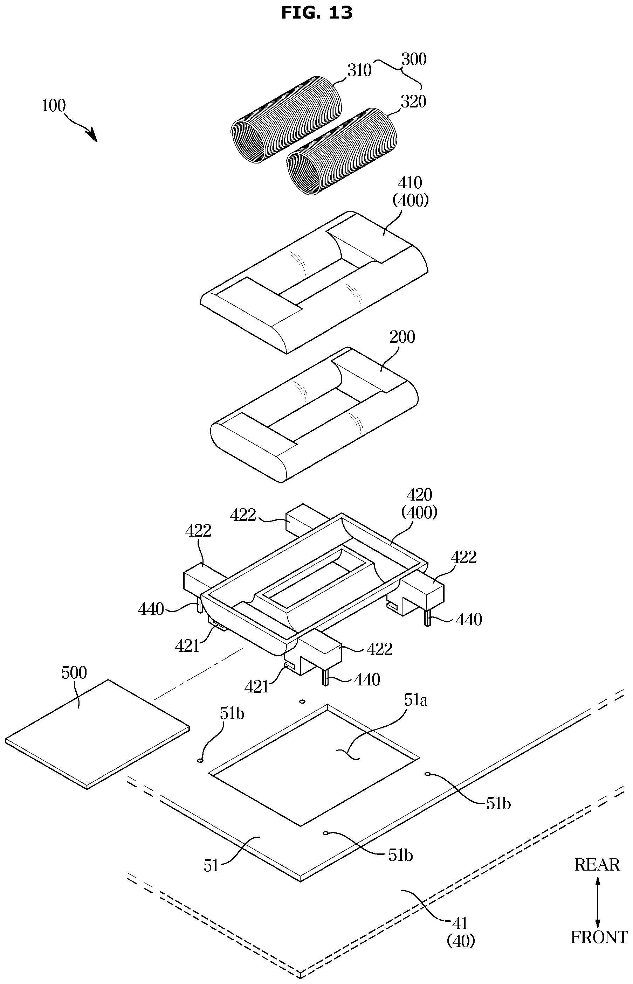

FIG. 12 shows a line filter of a display device according to another embodiment of the disclosure, wherein the line filter does not include a separator. FIG. 13 is an exploded perspective view of the line filter of FIG. 12.

A line filter of a display device according to another embodiment of the disclosure will be described with reference to FIGS. 12 and 13. In the following descriptions about the embodiment shown in FIGS. 12 and 13, like components as those shown in FIGS. 1 to 9 are assigned like reference numerals, and descriptions thereof may be omitted.

Referring to FIGS. 12 and 13, the line filter 100 may not include the separator 430 shown in FIGS. 1 to 9.

The coil 300 may be wound around at least a portion of the outer side of the core assembly 200 and 400 of the line filter 100, and the coil 300 may include the first coil 310 and the second coil 320 that are spaced from each other and wound. In other words, the first coil 310 may be wound around the first area of the outer side of the core assembly 200 and 400, and the second coil 320 may be wound around the second area of the outer side of the core assembly 200 and 400, the second area being opposite to the first area.

In this case, the first coil 310 and the second coil 320 may be arranged while maintaining a sufficient distance from each other. Accordingly, no separator for insulating the first coil 310 and the second coil 320 from each other may be provided between the first coil 310 and the second coil 320.

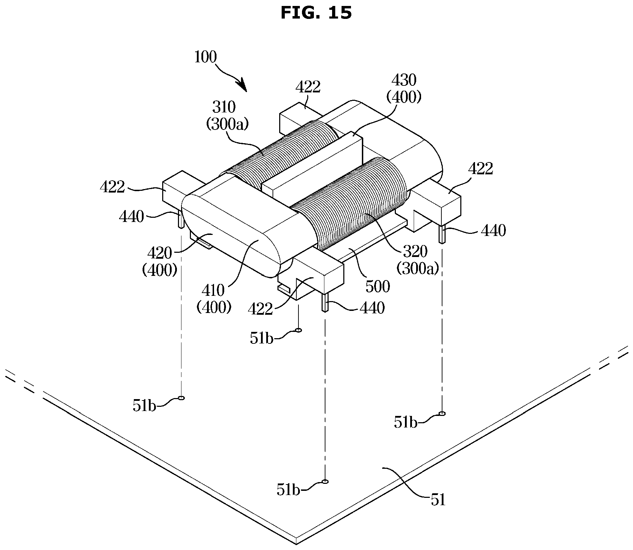

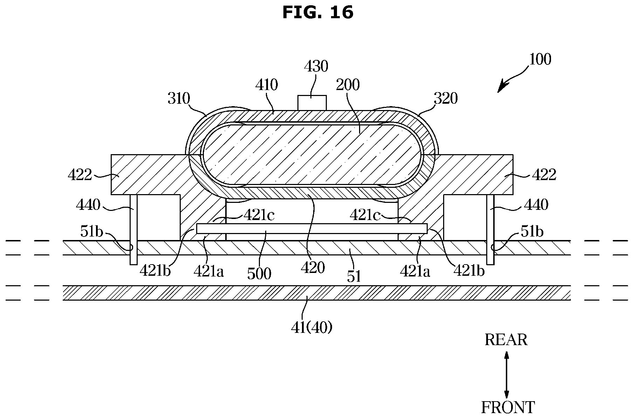

FIG. 14 shows a line filter of a display device according to another embodiment of the disclosure, wherein the line filter is mounted in a modified shape on a printed circuit board. FIG. 15 shows the line filter of FIG. 14 separated from the printed circuit board. FIG. 16 is a cross-sectional view taken along line Y-Y' of FIG. 14.

A line filter of a display device according to another embodiment of the disclosure will be described with reference to FIGS. 14 to 16. In the following descriptions about the embodiment shown in FIGS. 14 to 16, like components as those shown in FIGS. 1 to 9 are assigned like reference numerals, and descriptions thereof may be omitted.

Referring to FIGS. 14 to 16, the line filter 100 may be mounted on one surface of the printed circuit board 51.

More specifically, another portion of the line filter 100 except for at least the connection pin 440 may not be inserted in the printed circuit board 51. In other words, in the line filter 100, an entire of the core case 400 may be positioned on one side of the printed circuit board 51. That is, in the line filter 100, the entire of the core case 400 may be positioned on one side of the printed circuit board 51, which is opposite to the board mounting portion 41.

More specifically, the board hole 51a shown in FIGS. 5 to 9 may not be formed in the printed circuit board 51.

Accordingly, the shielding member 500 may be positioned between the printed circuit board 51 and the core 200, and the shield support portion 421 may be positioned between the printed circuit board 51 and the core 200.

As shown in FIG. 16, the core case 400 may be in contact with one surface of the printed circuit board 51, which is opposite to the board mounting portion 41. More specifically, the shield support portion 421 may be in contact with the one surface of the printed circuit board 51, which is opposite to the board mounting portion 41, although not limited thereto.

However, the shield support portion 421 may be spaced from the printed circuit board 51, and furthermore, the entire of the core case 400 may be spaced from the printed circuit board 51. Accordingly, the line filter 100 may be supported on the printed circuit board 51 only by the connection pin 440.

FIG. 17 shows a line filter of a display device according to another embodiment of the disclosure, wherein the line filter is configured to prevent separation of a shielding member by a coil. FIG. 18 is an enlarged view of A of FIG. 17.

A line filter of a display device according to another embodiment of the disclosure will be described with reference to FIGS. 17 and 18. In the following descriptions about the embodiment shown in FIGS. 17 and 18, like components as those shown in FIGS. 1 to 9 are assigned like reference numerals, and descriptions thereof may be omitted.

Referring to FIGS. 17 and 18, the line filter 100 may include the core 200, the core case 400 accommodating the core 200, and the coil 300 wound around the outer side of the core case 400, as described above.

The coil 300 may include the winding portion 300a wound around the outer side of the core case 400, and the connection end 300b extending from the winding portion 300a and connected to the connection pin 440. The coil 300 may be connected to the connection pin 440 by the connection end 300b and connected to the power terminals L and N such that current flows through the coil 300. While current flows through the coil 300, the winding portion 300a may generate a magnetic field by the current and generate an induced electromotive force.

The line filter 100 may include the shielding member 500 to shield an electric field or a magnetic field generated while the line filter 100 operates, and the core case 400 may support the shielding member 500. The shielding member 500 may be positioned between the core 200 and the board mounting portion 41, and the core case 400 may include the shield support portion 421 to support one surface of the shielding member 500 facing the board mounting portion 41.

The shield support portion 421 may include the first support portion 421a, the second support portion 421b, and the third support portion 421c, and further include the groove 421d which is formed between the first support portion 421a, the second support portion 421b, and the third support portion 421c and in which the shielding member 500 is inserted.

At least an end of the groove 421d in a direction in which the shielding member 500 is inserted into the groove 421d may open such that the shielding member 500 is easily inserted into the groove 421d. For example, at least an end of the groove 421d in a direction which is parallel to the extension direction of the board mounting portion 41 may open.

In this case, even after the shielding member 500 is inserted in the groove 421d, the shielding member 500 may move inside the groove 421d due to various causes, such as severe vibration of the product or gravity applied to the shielding member 500. Furthermore, due to severe movement of the shielding member 500 inside the groove 421d, the shielding member 500 may be separated from the shield support portion 421.

To overcome the problem, the shield support portion 421 may further include coil through holes 421e and 421f.

The coil 300 may penetrate the coil through holes 421e and 421f to prevent the shielding member 500 from being separated from the shield support portion 421. More specifically, at least a part of the coil 300 positioned between the winding portion 300a and the connection end 300b may penetrate the coil through holes 421e and 421f to prevent the shielding member 500 from being separated from the shield support portion 421.

The coil 300 may be provided such that a part of the coil 300 extending from the winding portion 300a covers one side of the shielding member 500 outside the shield support portion 421, penetrates the coil through holes 421e and 421f, and extends toward the connection pin 440.

More specifically, at least a part of the coil 300 positioned between the winding portion 300a and the connection end 300b may partially cover one side of the shield support portion 421 that opens such that the shielding member 500 is inserted into the shield support portion 421, while penetrating the coil through holes 421e and 421f. Accordingly, the shielding member 500 may be prevented from being separated from the shield support portion 421 by the part of the coil 300.

The one side of the shield support portion 421 that opens such that the shielding member 500 is inserted into the shield support portion 421 may be at least an end of the groove 421d that opens in a direction in which the shielding member 500 is inserted into the groove 421d.

The coil through holes 421e and 421f may include a first coil through hole 421e which a part of the coil 300 being adjacent to the winding portion 300a penetrates, and a second coil through hole 421f which a part of the coil 300 being adjacent to the connection end 300b penetrates. That is, the coil 300 may extend from the winding portion 300a, sequentially pass through the first coil through hole 421e and the second coil through hole 421f, extend to the connection end 300b, and be connected to the connection pin 440.

Each of the first coil through hole 421e and the second coil through hole 421f may penetrate the shield support portion 421.

For example, as shown in FIGS. 17 and 18, the first coil through hole 421e may penetrate the first support portion 421a. Also, the second coil through hole 421f may penetrate the second support portion 421b.

A part of the coil 300 positioned between the first coil through hole 421e and the second coil through hole 421f may be positioned inside the groove 421d. Accordingly, in order to prevent the shielding member 500 inserted in the groove 421d from interfering with the part of the coil 300 positioned inside the groove 421d, the shield support portion 421 may extend longer in an outward direction than an end of the shielding member 500. In other words, an outer end of the shield support portion 421 may protrude outward than the end of the shield member 500, and the end of the shield member 500 may be recessed from the outer end of the shield support portion 421.

That is, the shielding member 500 may be recessed in the direction in which the shielding member 500 is inserted into the groove 421d, thereby forming a space inside the groove 421d, which a part of the coil 300 penetrates, although not limited thereto.

However, the coil through holes 421e and 421f may be formed at various locations of the shield support portion 421.

For example, both the coil through holes 421e and 421f may penetrate the first support portion 421a, or the coil through holes 421e and 421f may respectively penetrate the first support portion 421a and the third support portion 421c. Furthermore, the coil through holes 421e and 421f may be provided such that at least a part of the coil 300 does not pass through the inside of the groove 421d.

The coil through holes 421e and 421f may be provided in each of the plurality of shield support portions 421. Alternatively, the coil through holes 421e and 421f may be provided only in any some of the plurality of shield support portions 421.

Furthermore, a structure (not shown) having a shape protruding from the outer side of the core case 400 (particularly, the core base 420) may be provided in the core case 400 to more firmly fix the coil 300 and more stably prevent the shielding member 500 from being separated from the shield support portion 421.

By this configuration, the shielding member 500 may be prevented from being separated from the shield support portion 421. However, the above-described characteristics about the locations, etc. of the coil through holes 421e and 421f may be only an example according to a concept of the disclosure, and the concept of the disclosure is not limited thereto. Unlike FIGS. 17 and 18, at least a part of the coil 300 positioned between the winding portion 300a and the connection end 300b may cover one side of the shielding member 500 in various manners to prevent the shielding member 500 from being separated from the shield support portion 421.

So far, specific embodiments have been shown and described. However, the disclosure is not limited to the above-described embodiments, and various modifications can be made by those skilled in the technical art to which the disclosure belongs without departing from the gist of the technical idea of the disclosure defined by the claims below.

## Claims

1. A display device comprising:
a display panel;
a display case supporting the display panel and including a board mounting portion;
a printed circuit board mounted on the board mounting portion; and
a line filter mounted on the printed circuit board and configured to reduce current noise, and
wherein the line filter comprises:
a core;
a shielding member positioned between the core and the board mounting portion and configured to shield an electric field or a magnetic field; and
a core case in which the core is accommodated, wherein a coil is wound around at least a portion of an outer side of the core case, the core case including a shield support portion supporting one surface of the shielding member facing the board mounting portion.

2. The display device of claim 1, wherein
the shielding member extends in parallel to the board mounting portion, and
the shield support portion extends in parallel to the shielding member and the board mounting portion.

3. The display device of claim 1, wherein
the shield support portion includes a first support portion facing the one surface of the shielding member facing the board mounting portion, and a second support portion supporting an outer edge of the shielding member, and
the second support portion is bent at and extends from one end of the first support portion.

4. The display device of claim 3, wherein
the shield support portion further comprises:
a third support portion facing the first support portion and supporting another surface of the shielding member which is opposite to the one surface of the shielding member facing the board mounting portion, and
a groove formed between the first support portion, the second support portion, and the third support portion such that the shielding member is inserted in the groove.

5. The display device of claim 4, wherein
the shielding member is insertable into the groove in parallel to the board mounting portion.

6. The display device of claim 4, wherein
the second support portion connects the first support portion and the third support portion.

7. The display device of claim 3, wherein
the first support portion and the second support portion extend in directions that are orthogonal to each other.

8. The display device of claim 1, wherein
the coil is wound around the core case in such a way as to extend in parallel to the board mounting portion, and
the shielding member covers one side of the coil facing the board mounting portion.

9. The display device of claim 8, wherein
the shield support portion includes a plurality of shield support portions arranged to be spaced from each other, and
the plurality of shield support portions are arranged in parallel to a direction in which the coil extends.

10. The display device of claim 1, wherein
a portion of the one surface of the shielding member facing the board mounting portion is covered by the shield support portion, and
another portion of the one surface of the shielding member facing the board mounting portion opens.

11. The display device of claim 1, wherein
the core is formed in an annular shape,
the core case is formed in an annular shape in correspondence with the core,
the coil includes a first coil wound around a first area of an outer side of the core and the core case, and a second coil wound around a second area of the outer side of the core and the core case, the second area being opposite to the first area,
the line filter further includes a separator configured to insulate the first coil and the second coil from each other, and
the shielding member is positioned between the separator and the board mounting portion.

12. The display device of claim 11, wherein
the separator is formed integrally with at least a portion of the core case adjacent to the board mounting portion.

13. The display device of claim 1, wherein
the line filter further includes a connection pin fixed to the printed circuit board and including a conductive material,
the coil includes a winding portion wound around the outer side of the core case and a connection end extending from the winding portion and connected to the connection pin,
the shield support portion includes a coil through hole formed between the shielding member and the board mounting portion, and
at least a part of the coil between the winding portion and the connection end penetrates the coil through hole to prevent the shielding member from being separated from the shield support portion.

14. The display device of claim 1, wherein
the printed circuit board includes a board hole in a location in which the line filter is mounted and formed to correspond to the core case, and
at least a part of the shield support portion is inserted in the board hole.

15. The display device of claim 1, wherein
the display case includes a bottom chassis supporting a rear side of the display panel, and
the board mounting portion is on a rear side of the bottom chassis.
